Europäisches Patentamt

European Patent Office

Office européen des brevets

(11) Veröffentlichungsnummer: **0 533 996 A1**

## (12) EUROPÄISCHE PATENTANMELDUNG

(21) Anmeldenummer: **91116606.4**

(51) Int. Cl.⁵: **G11C 7/00**, G06F 7/02

(22) Anmeldetag: **27.09.91**

(43) Veröffentlichungstag der Anmeldung:
**31.03.93 Patentblatt 93/13**

(84) Benannte Vertragsstaaten:
**AT BE CH DE DK ES FR GB GR IT LI LU NL SE**

(71) Anmelder: **SIEMENS AKTIENGESELLSCHAFT**
**Wittelsbacherplatz 2**
**W-8000 München 2(DE)**

(72) Erfinder: **Forbes, Alan, Dipl.-Ing.**
**Häberlstrasse 12**
**W-8000 München 2(DE)**

(54) **Integrierte Halbleiterspeicherschaltung.**

(57) Eine übliche integrierte Halbleiterspeicherschaltung weist zusätzlich eine Vielzahl von Komparatoreinrichtung (COMP) auf. Jede Komparatoreinrichtung (COMP) dient einem Vergleich von wenigstens zwei Daten (D1, D2). Die Ausgänge (OUT) der Komparatoreinrichtungen (COMP) sind mit einer gemeinsamen Leitung (L) verbunden, an der im Betrieb das Gesamtergebnis der in den Komparatoreinrichtungen (COMP) ausgeführten Vergleiche anliegt. Die Komparatoreinrichtungen (COMP) sind einzeln oder gruppenweise inhibierbar, so daß sie in inhibiertem Zustand die gemeinsame Leitung (L), und damit das Gesamtergebnis der Vergleiche der restlichen, nicht inhibierten Komparatoreinrichtungen (COMP) nicht beeinflussen.

FIG 1

EP 0 533 996 A1

Die Erfindung betrifft eine integrierte Halbleiterspeicherschaltung nach dem Oberbegriff des Patentanspruches 1.

Eine gattungsgemäße Halblleiterspeicherschaltung ist aus IEEE Journal of Solid-State Circuits, Vol. 24, No. 5, October 1989, "A 60ns 3.3-V-Only 16-MBit DRAM with Multipurpose Register", S. 1184 bis 1190 bekannt. Diese bekannte Schaltung hat jedoch, neben allen ihren Vorzügen, auch folgende Nachteile:
- Es können durch die dort enthaltenen Komparatoreinrichtungen nur solche Daten miteinander verglichen werden, die auf Bitleitungen von Bitleitungspaaren anliegen,
- es sind nur die Inhalte sämtlicher entlang einer Wortleitung angeordneter Speicherzellen paarweise miteinander vergleichbar.

Aufgabe der vorliegenden Erfindung ist es, eine integrierte Halbleiterspeicherschaltung zu schaffen, die bei einem Vergleich von Daten mehr Freizügigkeit bezüglich deren Auswahl erlaubt.

Diese Aufgabe wird bei einer gattungsgemäßen Halbleiterspeicherschaltung gelöst durch die kennzeichnenden Merkmale des Patentanspruches 1. Vorteilhafte Aus- und Weiterbildungen sind in Unteransprüchen gekennzeichnet.

Die Erfindung wird nachstehend anhand der Zeichnung näher erläutert. Es zeigen:

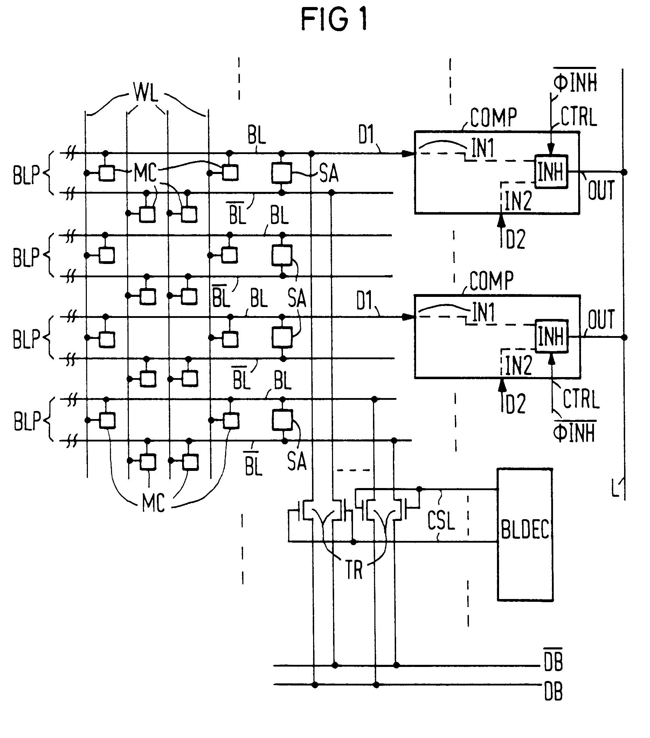

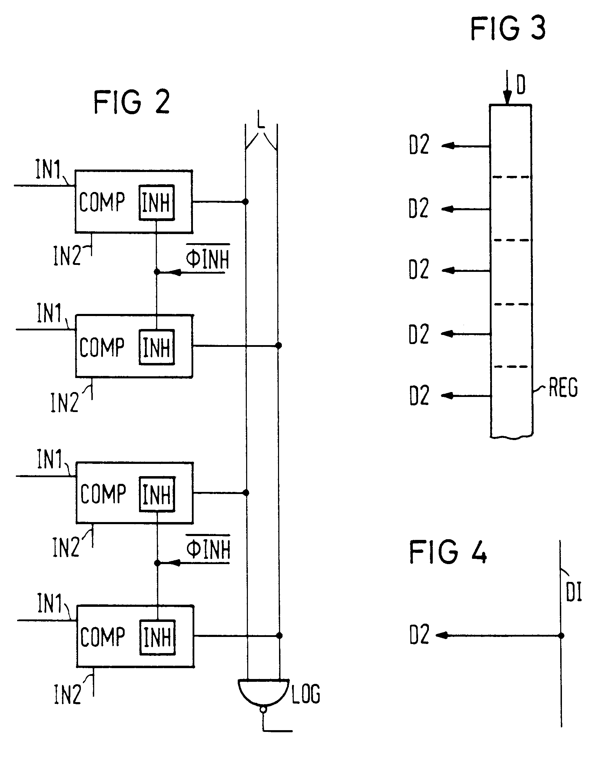

Die FIG 1 und 5 bis 7 vorteilhafte Ausführungsformen, die FIG 2 bis 4 und 8 bis 10 vorteilhafte Einzelheiten der Erfindung.

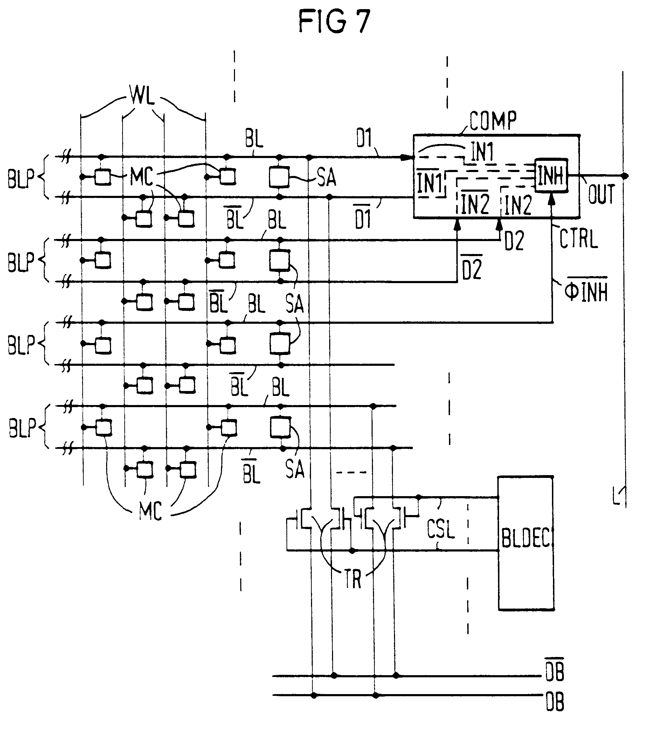

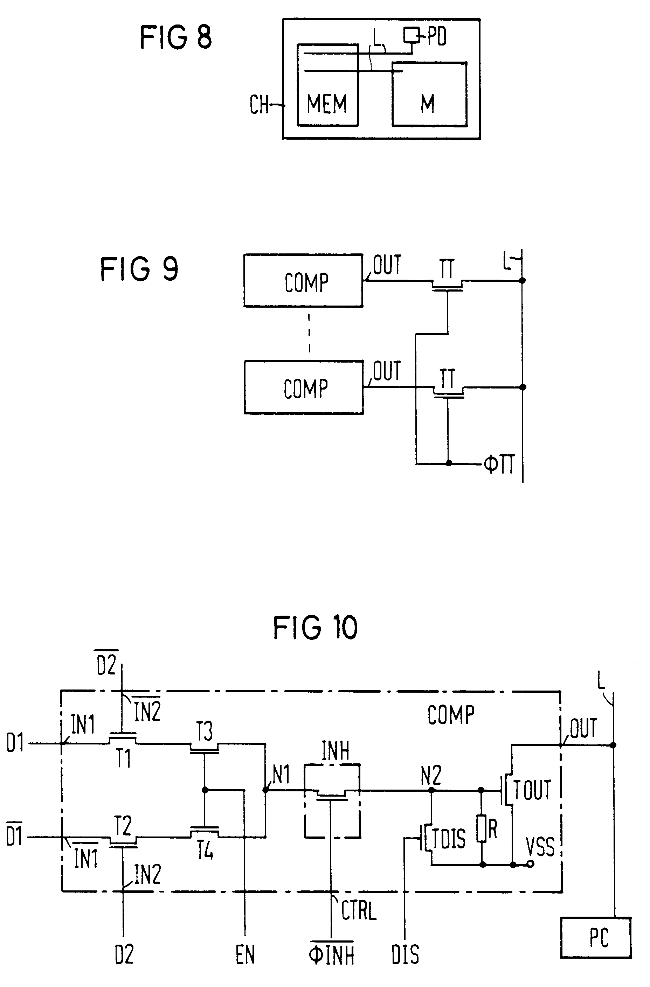

Vorab sei bemerkt, daß eine ausführliche Beschreibung der möglichen Funktionen der erfindungsgemäßen Halbleiterspeicherschaltung gegen Ende der Beschreibung anhand der FIG 7 und 10 erfolgt. Die Ausführungsform nach FIG 1 zeigt, ausschnittsweise und stark schematisiert dargestellt, eine erfindungsgemäße integrierte Halbleiterspeicherschaltung, die beispielsweise auf einem Halbleiterchip angeordnet ist, der über die Halbleiterspeicherschaltung hinaus noch sonstige elektronische Schaltungen enthalten kann. Die integrierte Halbleiterspeicherschaltung enthält eine Vielzahl von Speicherzellen MC, von Bitleitungspaaren BLP mit Bitleitungen BL, $\overline{BL}$, von Wortleitungen WL und Leseverstärkern SA. Jedes Bitleitungspaar BLP mit Bitleitungen BL, $\overline{BL}$ ist mit einem Leseverstärker SA verbunden. Die Speicherzellen MC sind matrixförmig entlang den Wortleitungen WL und den Bitleitungen BL, $\overline{BL}$ angeordnet. Die Wortleitungen WL sind über (nicht dargestellte) Wortleitungsdekoder, wie allgemein üblich, auswählbar, d. h. adressierbar. Jedes Paar BLP von Bitleitungen BL, $\overline{BL}$ ist über Auswahltransistoren TR mit einem Paar von Datenbusleitungen DB, $\overline{DB}$ verbindbar. Es können auch, wie allgemein bekannt, mehrere Paare von Datenbusleitungen DB, $\overline{DB}$ vorhanden sein. Die Auswahltransistoren TR werden über Auswahlleitungen CSL von einem Bitleitungsdekoder BLDEC angewählt.

FIG 1 zeigt fernerhin Komparatoreinrichtungen COMP. Zwar sind aus Gründen der Übersichtlichkeit nur zwei Komparatoreinrichtungen COMP dargestellt, jedoch ist erfindungsgemäß eine Vielzahl solcher Komparatoreinrichtungen COMP vorgesehen, beispielsweise eine Komparatoreinrichtung COMP je Bitleitungspaar BLP. Jede Komparatoreinrichtung COMP dient einem Vergleich von wenigstens zwei Daten D1, D2. Zu diesem Zweck können die Komparatoreinrichtung COMP aus dem Stand der Technik her bereits bekannte XOR-, XNOR-, OR-, NOR-, AND- oder NAND-Schaltungen enthalten. Diese Schaltungen sind also solche in den FIG 1 und 5 bis 7 nicht dargestellt, da dem Fachmann aus dem Stand der Technik bereits bekannt. Sie sind jedoch symbolisch angedeutet durch die punktierte Verbindung zwischen den Eingängen IN1, IN2 (und ggf. $\overline{IN1}$, $\overline{IN2}$) mit einem Mittel zum Inhibieren INH. Für die weitere Beschreibung sei angenommen, daß jede Komparatoreinrichtung COMP unter anderem eine XOR-Schaltung entsprechend dem eingangs genannten Artikel aus "IEEE Journal of Solid-State Circuits" enthalte.

Bei jeder Komparatoreinrichtung COMP liegt das erste Datum D1 der beiden Daten D1, D2 über eine Bitleitung, beispielsweise in FIG 1 über die eine Bitleitung BL eines Bitleitungspaares BLP an einem ersten Dateneingang IN1 an. Das zweite Datum D2 der beiden Daten D1, D2 liegt an einem zweiten Dateneingang IN2 der Komparatoreinrichtung COMP an. Die Komparatoreinrichtungen COMP weisen Ausgänge OUT auf, die mit einer gemeinsamen Leitung L verbunden sind. Eine solche integrierte Halbleiterspeicherschaltung ist beispielsweise aus dem eingangs genannten Artikel in "IEEE Journal of Solid-State Circuits" bekannt, wobei dort der zweite Dateneingang allerdings mit einer einer Bitleitung entsprechenden Leitung verbunden ist, während dies bei der vorliegenden Erfindung nicht notwendigerweise der Fall ist (wird noch erläutert).

Erfindungsgemäß weist jede Komparatoreinrichtung COMP der integrierten Halbleiterspeicherschaltung darüberhinaus noch ein Mittel zum Inhibieren INH ihres Ausganges OUT auf. Im einfachsten Fall ist dies ein Transfertransistor, wie in FIG 10 noch gezeigt wird. In dem Fall, in dem der Ausgang OUT inhibiert ist, weist er einen elektrischen Zustand auf, der den elektrischen Zustand, den die gemeinsame Leitung L vor Durchführen des Vergleiches aufweist, unbeeinflußt läßt. Vorteilhaft ist es, wenn dieser Zustand ein hochohmiger Zustand ist ("tristate").

Mit der vorliegenden Erfindung ist es je nach Ausführungsform möglich, zu ermitteln, ob bei allen Komparatoreinrichtungen COMP, deren Ausgänge OUT nicht inhibiert sind und deren Ausgänge OUT mit ein und derselben gemeinsamen Leitung L verbunden sind, an deren jeweiligem ersten Dateneingang IN1 ein erstes Datum D1 anliegt, das unterschiedlich zu oder gleich dem am jeweiligen zweiten Dateneingang IN2 anliegenden zweiten Datum D2 ist.

Es ist, je nach Anwendungsfall der erfindungsgemäßen Halbleiterspeicherschaltung, einerseits vorteilhaft, wenn bei jeder Komparatoreinrichtung COMP das Mittel zum Inhibieren INH ihres Ausganges OUT separat ansteuerbar ist, z. B. mittels eines Inhibit-Signales $\overline{\phi INH}$, wie in FIG 1 dargestellt (die dort dargestellten beiden Inhibit-Signale $\overline{\phi INH}$ sollen, trotz identischer Bezeichnung, physikalisch voneinander getrennte, unabhängige Inhibit-Signale sein). Andererseits ist es (in anderen Anwendungsfällen) auch vorteilhaft, wenn jeweils eine Gruppe von Mitteln zum Inhibieren INH gemeinsam inhibierbar ist, d. h. daß die Ausgänge OUT einer Gruppe von Komparatoreinrichtungen COMP gemeinsam in den Zustand schaltbar sind, in dem die gemeinsame Leitung L unbeeinflußt ist.

Dies ist in FIG 2 angedeutet, welche (ausschnittsweise) im Prinzip die erfindungsgemäße Schaltung nach FIG 1 zeigt, jedoch mit folgenden Unterschieden: Zum einen beeinflußt ein einzelnes Inhibit-Signal $\overline{\phi INH}$ jeweils zwei Mittel zum Inhibieren INH, und damit jeweils zwei Komparatoreinrichtungen COMP gemeinsam. Zum anderen zeigt sie aber auch die Möglichkeit, eine erste Gruppe der Komparatoreinrichtungen COMP ausgangsmäßig mit einer ersten gemeinsamen Leitung L zu verbinden und eine zweite Gruppe der Komparatoreinrichtungen COMP ausgangsmäßig mit einer zweiten gemeinsamen Leitung L zu verbinden. Diese mehreren gemeinsamen Leitungen L können dann als Eingänge für ein Logikgatter LOG dienen, wie in FIG 2 anhand eines NAND-Gatters dargestellt.

FIG 3 zeigt ausschnittsweise eine besondere Ausführungsform zu FIG 1: Die für die einzelnen Komparatoreinrichtungen COMP verschiedenen zweiten Daten D2 sind dabei in einem (oder entsprechend mehreren) Register REG gespeichert, welches beispielsweise über eine Datenleitung D ladbar ist. Das Register REG hat, entsprechend seinen Speicherstellen, mehrere Ausgänge, die mit den zweiten Dateneingängen IN2 der Komparatoreinrichtungen COMP verbunden sind.

FIG 4 zeigt eine weitere Möglichkeit für die Zuführung der einzelnen zweiten Daten D2 an die Komparatoreinrichtungen COMP. Nach FIG 4 ist das jeweilige zweite Datum D2 der jeweiligen Komparatoreinrichtung COMP über eine solche Leitung der Halbleiterspeicherschaltung während des Vergleichsvorganges zuführbar, die außerhalb des Vergleichsvorganges ein sonstiges Signal wie z. B. ein Dateneingangssignal DI (wie dargestellt) führt.

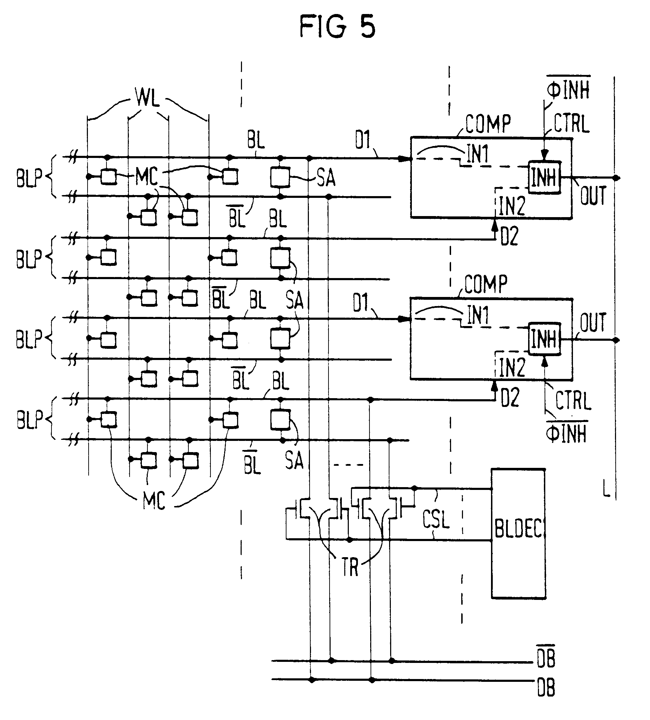

Die Ausführungsform nach FIG 5 unterscheidet sich von der Ausführungsform nach FIG 1 insoweit, als bezüglich der ersten Daten D1 nicht mehr, wie bei FIG 1 angenommen, jedem Bitleitungspaar BLP eine Komparatoreinrichtung COMP mit ihrem ersten Dateneingang IN1 zugeordnet ist, sondern beispielsweise nur noch jedem zweiten Bitleitungspaar BLP. Das zweite Datum D2 einer jeweiligen Komparatoreinrichtung COMP ist dabei (beispielsweise) über die eine Bitleitung BL jedes anderen zweiten Paares BLP von Bitleitungen zuführbar. Für eine Komparatoreinrichtung COMP gilt also (beispielsweise) folgendes: Über die eine Bitleitung BL eines ersten Bitleitungspaares BLP ist der Komparatoreinrichtung COMP das erste Datum D1 zuführbar. Über die eine Bitleitung BL eines zweiten Bitleitungspaares BLP ist der Komparatoreinrichtung COMP das zweite Datum D2 zuführbar. Da bezüglich des Einschreibens von Daten in Speicherzellen MC (wie, im übrigen, auch bezüglich eines Auslesens von Daten aus diesen ohne Ausnützen der Möglichkeiten der Komparatoreinrichtungen COMP) die Halbleiterspeicherschaltung genauso betreibbar ist wie beispielsweise ein übliches RAM, sind in diesem Fall sowohl die ersten Daten D1 wie auch die zweiten Daten D2 ohne Mehraufwand (weder an Schaltung noch an Einschreibzeit) in die Halbleiterspeicherschaltung einschreibbar, verglichen beispielsweise mit einem üblichen RAM. Auch das Vergleichen kann, ohne schaltungstechnischen Mehraufwand gegenüber den FIG 2 bis 4, einfach und individuell bezüglich jedes zweiten Datums D2 erfolgen, weil das zweite Datum D2 nicht separat (von anderen Schaltungsteilen der Halbleiterspeicherschaltung oder von sonstigen Teilen des Halbleiterchips her) zuzuführen ist, sondern über sowieso vorhandene Bitleitungen BL, $\overline{BL}$ der Halbleiterspeicherschaltung jeder einzelnen Komparatoreinrichtung COMP zuführbar ist.

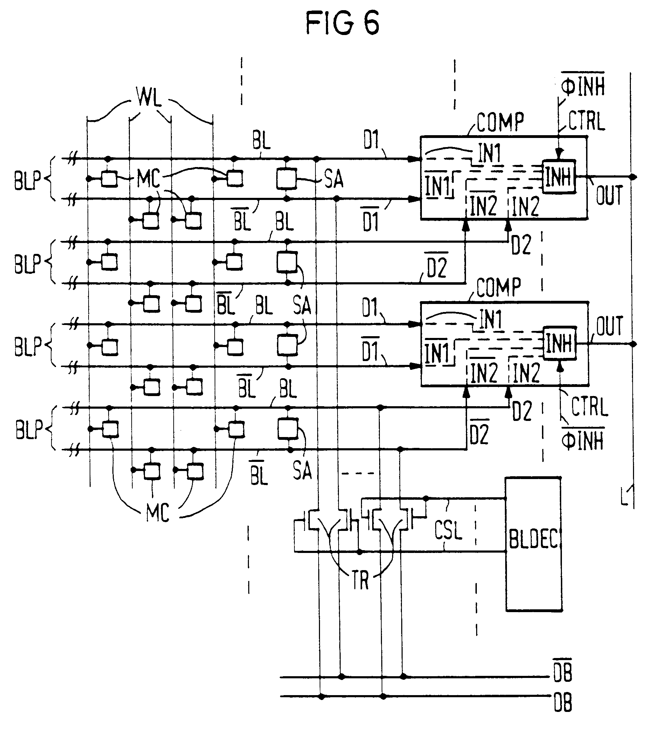

FIG 6 stellt eine weitere, günstige Ausgestaltung der vorliegenden Erfindung dar. Sie ist, vom Grundsatz her, genauso aufgebaut wie die Ausführungsform nach FIG 5. Jede Komparatoreinrichtung COMP hat allerdings doppelt so viele Dateneingänge wie die bisher beschriebenen Ausführungsformen: Sie weist zum einen den ersten Dateneingang IN1 für das erste Datum D1 auf und den zweiten Dateneingang IN2 für das zweite Datum D2. Darüberhinaus weist sie einen weiteren ersten Dateneingang $\overline{IN1}$ auf. An diesem liegt das erste Datum, das am ersten Dateneingang IN1 in wahrer Form (D1) anliegt, in dazu komplementärer Form ($\overline{D1}$) an. Weiterhin weist sie einen weiteren zweiten Dateneingang $\overline{IN2}$ auf. An diesem liegt das zweite Datum, das am zweiten Dateneingang IN2 in wahrer Form (D2) anliegt, in dazu komplementärer Form ($\overline{D2}$) an. Der Vorteil dieser Ausführungsform liegt darin, daß die zu vergleichenden Daten D1, D2 an der jeweiligen Komparatoreinrichtung COMP sowohl in wahrer (D1, D2) wie auch in komplementärer Form ($\overline{D1}$, $\overline{D2}$) anliegen, was die Ausgestaltung der Komparatoreinrichtungen COMP technisch vereinfacht (vgl. dazu auch FIG 10).

FIG 7 zeigt eine besonders vorteilhafte Ausführungsform der Erfindung, bei der sowohl die zu vergleichenden Daten D1, D2 (bzw. entsprechend deren dazu komplementäre Daten $\overline{D1}$, $\overline{D2}$) und die Inhibit-Signale $\overline{\phi INH}$ der einzelnen Komparatoreinrichtungen COMP in Speicherzellen MC der Halbleiterspeicherschaltung entlang einer Wortleitung WL speicherbar (und damit gleichzeitig abrufbar) sind: Damit ist bezüglich der in FIG 7 beispielhaft gezeigten einen Komparatoreinrichtung COMP (als einer von vielen) folgendes möglich: entlang einer (im Betrieb ausgewählten) Wortleitung WL ist in einer Speicherzelle MC eines ersten Bitleitungspaares BLP das erste Datum D1 gespeichert. Entlang derselben Wortleitung WL ist in einer Speicherzelle MC eines zweiten Bitleitungspaares BLP das zweite Datum D2 gespeichert.

Entlang (wiederum) derselben Wortleitung WL ist in einer Speicherzelle MC eines weiteren, dritten Bitleitungspaares BLP ein Datum gespeichert, welches seiner Bedeutung nach dem Inhibit-Signal $\overline{\phi INH}$ der betrachteten Komparatoreinrichtung COMP entspricht. Diese ist somit mit ihren ersten und zweiten Dateneingängen IN1, $\overline{IN1}$, IN2, $\overline{IN2}$ mit den Bitleitungen BL, $\overline{BL}$ des ersten und des zweiten Bitleitungspaares BLP verbunden und mit ihrem Steuereingang CTRL mit der einen Bitleitung BL des dritten Bitleitungspaares BLP.

FIG 8 zeigt (gleichzeitig) drei verschiedene Ausführungsformen bezüglich der gemeinsamen Leitung(-en) L. Dabei ist angenommen, daß sich, was an und für sich selbstverständlich ist, die erfindungsgemäße integrierte Halbleiterspeicherschaltung MEM auf bzw. in einem Halbleiterchip CH befindet. Bei der einen dargestellten Ausführungsform ist die gemeinsame Leitung L mit einem Anschlußpad PD des Halbleiterchips CH verbunden, so daß das Vergleichsergebnis jeweils direkt am Pad PD bzw. an einem damit verbundenen Anschlußpin des Halbleiterchips CH anliegt und elektrisch zugänglich ist. Bei der anderen in FIG 8 dargestellten Ausführungsform enthält der die erfindungsgemäße Halbleiterspeicherschaltung MEM enthaltende Halbleiterchip CH noch zusätzlich elektronische Schaltmittel M. Eine solche integrierte Schaltung ist als solche üblicherweise unter dem allgemeinem Begriff "ASIC" bekannt. Erfindungsgemäß ist hier vorgesehen, daß die gemeinsame Leitung L der integrierten Halbleiterspeicherschaltung MEM mit dem elektrischen Schaltmittel M verbunden ist, so daß beispielsweise das an der gemeinsamen Leitung L anliegende Vergleichsergebnis sofort, ohne Laufzeitverluste, durch das elektronische Schaltmittel M verarbeitbar ist.

FIG 8 zeigt aber auch die Kombination aus diesen beiden geschilderten Ausführungsformen. Dabei ist angenommen, daß die erfindungsgemäße integrierte Halbleiterspeicherschaltung wenigstens zwei verschiedene gemeinsame Leitungen L aufweist. Die eine gemeinsame Leitung L ist mit dem einen Anschlußpad PD des Halbleiterchips CH verbunden. Die andere gemeinsame Leitung L ist mit dem elektronischen Schaltmittel M verbunden.

Bei der Ausführungsform nach FIG 9 sind die Ausgänge OUT der Komparatoreinheiten COMP über Transfertransistoren TT mit der gemeinsamen Leitung L verbunden. Dabei ist es vorteilhaft, wenn sie, wie dargestellt, gemeinsam mit einem Steuersignal $\phi TT$ steuerbar sind. Damit ist die gemeinsame Leitung L von den Komparatoreinrichtungen COMP elektrisch trennbar, so daß die gemeinsame Leitung L in den Fällen, in denen keine Vergleiche mittels der Komparatoreinrichtungen COMP durchgeführt werden, für sonstige Zwecke elektrisch nutzbar.

FIG 10 zeigt die vorteilhafte Ausführungsform einer Komparatoreinrichtung COMP nach der vorliegenden Erfindung: Zwischen dem ersten Dateneingang IN1 und einem ersten Schaltungsknoten N1 sind ein Transistor T1 eines ersten Transistorpaares T1, T2 und ein Transistor T3 eines zweiten Transistorpaares T3, T4 mit ihren stromführenden Pfaden (= Kanälen) angeordnet. Entsprechend sind zwischen dem weiteren ersten Dateneingang $\overline{IN1}$ und dem ersten Schaltungsknoten N1 ein Transistor T2 des ersten Transistorpaares T1, T2 und ein Transistor T4 des zweiten Transistorpaares T3, T4 mit ihren stromführenden Pfaden angeordnet. Ob die Transistoren T1, T2 des ersten Transistorpaares T1, T2 zwischen dem ersten (IN1) bzw. dem weiteren ersten Dateneingang ($\overline{IN1}$) einerseits und dem jeweiligen Transistor T3, T4 des zweiten Transistorpaares andererseits angeordnet sind oder zwischen den jeweiligen Transistoren T3, T4 des zweiten Transistorpaares und dem ersten Schaltungsknoten N1, ist schaltungstechnisch irrelevant. Das Gate des einen Transistors T1 des ersten Transistorpaares T1, T2 ist mit dem weiteren zweiten Dateneingang $\overline{IN2}$ verbunden. Das Gate des anderen Transistors T2 des ersten Transistorpaares T1, T2 ist mit dem zweiten Dateneingang IN2 verbunden. Die Gates der Transistoren des zweiten Transistorpaares T3, T4 sind mit einem Enable-Signal EN beaufschlagt, welches im Betrieb, d. h. während einer Vergleichsoperation, seinen aktiven Zustand aufweist. Sollen keine Vergleichsoperationen ausgeführt werden, so ist das Enable-Signal EN zu deaktivieren.

Das Mittel zum Inhibieren INH ist in Form eines Transfertransistors zwischen dem ersten (N1) und einem zweiten Schaltungsknoten N2 angeordnet. Dieser Transfertransistor ist gatemäßig über den Steuereingang CTRL der Komparatoreinrichtung COMP mit dem Inhibit-Signal $\overline{\phi INH}$ verbunden. Über das Inhibit-Signal $\overline{\phi INH}$ wird die Inhibit-Funktion des Ausganges OUT gesteuert. Bei der gezeigten Ausführungsform ist angenommen, daß die Inhibit-Funktion dann aktiviert ist, wenn das Inhibit-Signal $\overline{\phi INH}$ einen niedrigen Potentialwert aufweist (dann ist der zugehörige Transfertransistor elektrisch gesperrt) und daß die Inhibit-Funktion dann deaktiviert ist, wenn das Inhibit-Signal $\overline{\phi INH}$ einen hohen Potentialwert aufweist (dann ist der zugehörige Transfertransistor elektrisch leitend).

Zwischen dem zweiten Schaltungsknoten N2 und dem niedrigen Versorgungspotential VSS der integrierten Halbleiterspeicherschaltung ist ein Disable-Transistor TDIS mit seinem Kanal angeordnet. Sein Gate ist mit einem Disable-Signal DIS beaufschlagbar. Bei der Ausführungsform nach FIG 10 ist angenommen, daß das Disable-Signal DIS einen zeitlichen Verlauf aufweist, der komplementär ist zum zeitlichen Verlauf des Enable-Signals EN. Es ist jedoch auch möglich, daß das Disable-Signal DIS wenigstens zeitweise denselben Verlauf aufweist wie das Enable-Signal EN. In diesem Fall wäre als Disable-Transistor TDIS ein Transistor vom p-Kanal-Typ vorzusehen (in FIG 10 ist ein solcher vom n-Kanal-Typ angenommen), der mit dem hohen Versorgungspotential VDD der Halbleiterspeicherschaltung verbunden ist (anstelle der Verbindung mit dem niedrigen Versorgungspotential VSS).

FIG 10 zeigt weiterhin einen Ausgangstransistor TOUT, dessen Kanal zwischen dem Ausgang OUT der Komparatoreinrichtung COMP und dem niedrigen Versorgungspotential VSS liegt (auch hier ist eine Verbindung mit dem hohen Versorgungspotential VDD möglich, wenn als Ausgangstransistor OUT ein Transistor vom p-Kanal-Typ gewählt wird). Das Gate des Ausgangstransistors TOUT ist mit dem zweiten Schaltungsknoten N2 verbunden.

Nachstehend wird nun die Funktion der erfindungsgemäßen integrierten Halbleiterspeicherschaltung nach FIG 7 in Verbindung mit der in FIG 10 dargestellten vorteilhaften Komparatoreinrichtung COMP erläutert. Dabei ist zwar grundsätzlich angenommen, daß die integrierte Halbleiterspeicherschaltung nach FIG 7 zusätzlich zu der einen dargestellten Komparatoreinrichtung COMP noch mehrere Komparatoreinrichtungen COMP enthält, von denen jede eingangsmäßig genau so beschaltet ist wie die eine dargestellte Komparatoreinrichtung COMP, d. h. deren erste Dateneingänge IN1, $\overline{IN1}$ und deren zweite Dateneingänge IN2, $\overline{IN2}$ sind mit den Bitleitungen BL, $\overline{BL}$ der ersten bzw. zweiten Bitleitungspaare BLP verbunden und deren Steuereingänge CTRL sind mit den Bitleitungen BL anderer, weiterer Bitleitungspaare BLP verbunden.

Zur Erläuterung der Funktion der Komparatoreinrichtungen COMP als solcher ist in einer ersten Betriebsart angenommen, daß alle Komparatoreinrichtungen COMP bis auf eine einzige inhibiert sind, so daß nur diese eine Komparatoreinrichtung COMP betrachtet wird. In einem ersten Zyklus wird der Inhalt aller Speicherzellen MC entlang einer adressierten Wortleitung WL auf die zugehörige Bitleitung BL (bzw. $\overline{BL}$, je nach adressierter Wortleitung WL) ausgelesen sowie durch den jeweils zugehörigen Leseverstärker SA bewertet und verstärkt. Dieser Vorgang ist, für sich allein betrachtet, bei Halbleiterspeichern ein allgemein üblicher Auslesevorgang.

Spätestens zu Beginn eines daran anschließenden Vergleichszyklus (der nur dann eintritt, wenn das Enable-Signal EN aktiviert ist, d. h. wenn die Vergleichsfunktion gewünscht ist) wird die gemeinsame Leitung L mittels einer Precharge-Einrichtung PC auf eines der Versorgungspotentiale der Halbleiterspeicherschaltung vorgeladen (hier verwendbare Precharge-Einrichtungen PC sind für sich als solche bereits beispielsweise aus der EP-A 0 283 907 bekannt). Im Beispiel sei angenommen, daß dies das (positivere) Versorgungspotential VDD der Halbleiterspeicherschaltung sei.

Das Disable-Signal DIS weist für alle Komparatoreinrichtungen COMP zunächst einen hohen Pegel auf und nimmt dann (wieder) einen niedrigen Pegel an. Damit gelangt an die Gates der Ausgangstransistoren TOUT über die jeweiligen Disable-Transistoren TDIS und die zweiten Schaltungsknoten N2 kurzzeitig das (niedrigere) Versorgungspotential VSS. Dadurch sind die Ausgangstransistoren TOUT sicher gesperrt, die Ausgänge OUT der Komparatoreinrichtungen COMP sind hochohmig, die gemeinsame Leitung L bleibt aufgrund ihrer vorhandenen parasitären Kapazitäten auf dem Vorladepotential. Zusätzlich oder anstelle des Disable-Signales DIS kann zwischen dem zweiten Schaltungsknoten N2 jede Komparatoreinrichtung COMP und dem (niedrigeren) Versorgungspotential VSS auch ein hochohmiger Widerstand R vorgesehen sein.

Das Enable-Signal EN kann in dem (angenommenen) Fall, in dem Vergleiche mittels der Komparatoreinrichtungen COMP durchzuführen sind, das heißt in dem Fall, in dem die Halbleiterspeicherschaltung nicht nur als üblicher Halbleiterspeicher betrieben werden soll, entweder ständig ein hohes Potential aufweisen, oder aber es kann einen zum Disable-Signal DIS komplementären Verlauf aufweisen. Vorliegend sei angenommen, daß es ständig ein hohes Potential aufweist (in dem, hier nicht zu betrachtenden Fall, in dem die integrierte Halbleiterspeicherschaltung als üblicher Halbleiterspeicher betrieben werden soll, d. h. genauso wie ein üblicher Halbleiterspeicher ohne die Komparatoreinrichtungen COMP und ohne die gemeinsame Leitung L mit der Precharge-Vorrichtung PC, weist das Enable-Signal EN stets ein niedriges Potential auf, so daß die Transistoren T3, T4 des zweiten Transistorpaares stets gesperrt sind, wodurch letztendlich die Ausgänge OUT stets hochohmig sind.

An den ersten Dateneingängen IN1, $\overline{IN1}$ der Komparatoreinrichtungen COMP liegen die ersten Daten D1, $\overline{D1}$ an, die über erste Bitleitungspaare BLP aus den Speicherzellen MC entlang der adressierten Wortleitung WL ausgelesen worden sind. An den zweiten Dateneingängen IN2, $\overline{IN2}$ der Komparatoreinrichtungen COMP liegen die zweiten Daten D2, $\overline{D2}$ an, die über zweite Bitleitungspaare BLP aus den Speicherzellen MC entlang der adressierten Wortleitung WL ausgelesen worden sind.

An den Steuereingängen CTRL derjenigen Komparatoreinrichtungen COMP, die aufgrund der angenommenen ersten Betriebsart inhibiert sein sollen, liegen Inhibit-Signale $\phi\overline{INH}$ an, die ein niedriges Potential aufweisen, d. h. an jeder Bitleitung BL von dritten Bitleitungspaaren BLP liegt ein gespeichertes Datum "log. 0" an, welches aus der entsprechenden, mit der adressierten Wortleitung WL verbundenen Speicherzelle MC ausgelesen worden ist.

Wegen dieses niedrigen Potentials ist das als Transfertransistor realisierte Mittel zum Inhibieren INH stets gesperrt. Damit bleiben aber die Ausgangstransistoren TOUT derjenigen Komparatoreinrichtungen COMP, die inhibiert sein sollen, ebenfalls gesperrt, so daß die Ausgänge OUT hochohmig bleiben, unabhängig von den Daten D1, $\overline{D1}$, D2, $\overline{D2}$ an den ersten und zweiten Dateneingängen IN1...$\overline{IN2}$.

Am Steuereingang CTRL derjenigen Komparatoreinrichtung COMP, die nicht inhibiert sein soll, weist das Inhibit-Signal $\phi\overline{INH}$ ein hohes Potential auf, d. h., aus derjenigen Speicherzelle MC, die mit diesem Steuereingang CTRL über ihre zugehörige Bitleitung BL eines dritten Bitleitungspaares BLP verbunden ist, wurde ein gespeichertes Datum "log. 1" ausgelesen.

Wenn nun am ersten Dateneingang IN1 ein Datum D1 mit hohem Potential anliegt und am zweiten Dateneingang IN2 ein Datum D2 mit ebenfalls hohem Potential, dann liegen naturgemäß (weil auf den Bitleitungen BL, $\overline{BL}$ eines Bitleitungspaares BLP stets zueinander komplementäre Daten anliegen nach einem Auslesen aus einer Speicherzelle MC) am weiteren ersten Dateneingang $\overline{IN1}$ und am weiteren zweiten Dateneingang $\overline{IN2}$ Daten $\overline{D1}$, $\overline{D2}$ vom niedrigen Potential an. Dies bedeutet aber, daß der eine Transistor T1 des ersten Transistorpaares T1, T2 gesperrt ist, so daß das erste Datum D1 nicht auf den ersten Schaltungsknoten N1 gelangen kann. Das am weiteren ersten Dateneingang $\overline{IN1}$ anliegende weitere erste Datum $\overline{D1}$ vom niedrigen Potential wird jedoch über den anderen Transistor T2 des ersten Transistorpaares T1, T2 und den anderen Transistor T4 des zweiten Transistorpaares T3, T4 auf den ersten Schaltungsknoten N1 durchgeschaltet, da diese beiden Transistoren T2, T4 beide elektrisch leitend sind (deren Gates sind beide auf hohem Potential, da sowohl das zweite Datum D2 wie auch das Enable-Signal EN ein hohes Potential aufweisen). Das niedrige Potential am ersten Schaltungsknoten N1 wird wegen des hohen Potentials (Inhibit-Signal $\phi\overline{INH}$) am Gate des Transfertransistors des Mittels zum Inhibieren INH auf den zweiten Schaltungsknoten N2 und somit an das Gate des Ausgangstransistors TOUT durchgeschaltet. Deshalb bleibt dieser auch weiterhin gesperrt, so daß der Ausgang OUT der Komparatoreinrichtung COMP hochohmig bleibt. Damit bleibt auch die gemeinsame Leitung L unbeeinflußt, d. h. sie bleibt auf ihrem vorgeladenen Zustand (hohes Versorgungspotential VDD).

Wenn nun, in einem anderen Fall, sowohl am ersten Dateneingang IN1 wie auch am zweiten Dateneingang IN2 Daten D1, D2 mit niedrigem Potential anliegen und an den weiteren Dateneingängen $\overline{IN1}$, $\overline{IN2}$ weitere Daten $\overline{D1}$, $\overline{D2}$ mit hohem Potential anliegen, so geschieht bezüglich des Ausganges OUT genau dasselbe wie bereits geschildert (Ausgang OUT bleibt hochohmig, gemeinsame Leitung L bleibt auf ihrem vorgeladenen Zustand):

Zwar ist nun der andere Transistor T2 des ersten Transistorpaares T1, T2 gesperrt, da der zweite Dateneingang IN2 ein niedriges Potential aufweist. Dafür ist jedoch der eine Transistor T1 des ersten Transistorpaares T1, T2 leitend (weiterer zweiter Dateneingang $\overline{IN2}$: hohes Potential), so daß das niedrige Potential des ersten Dateneingangs IN1 über die einen Transistoren T1, T3 der beiden Transistorpaare T1, T2 und T3, T4 auf den ersten Schaltungsknoten N1 durchgeschaltet ist. Damit jedoch herrschen am Mittel zum Inhibieren INH und am Ausgangstransistor TOUT dieselben Potential- und Schaltverhältnisse wie im zuerst geschilderten Fall.

In einem dritten Fall sei nun angenommen, daß am ersten Dateneingang IN1 und am weiteren zweiten Dateneingang $\overline{IN2}$ ein hohes Potential anliege und daß am weiteren ersten Dateneingang $\overline{IN1}$ und am zweiten Dateneingang IN2 ein niedriges Potential anliege. In diesem Fall ist zwar der andere Transistor T2 des ersten Transistorpaares T1, T2 gesperrt, aber die einen Transistoren T1, T3 der beiden Transistorpaare T1, T2 und T3, T4 sind leitend, weil an ihren Gates jeweils ein hohes Potential anliegt. Damit wird das hohe Potential des ersten Dateneingangs IN1 auf den ersten Schaltungsknoten N1 durchgeschaltet. Da das Inhibit-Signal $\overline{\phi \text{INH}}$ ebenfalls ein hohes Potential aufweist (die eine betrachtete Komparatoreinrichtung COMP soll ja vereinbarungsgemäß nicht inhibiert sein), gelangt das hohe Potential des ersten Schaltungsknotes N1 über das Mittel zum Inhibieren INH an das Gate des Ausgangstransistors TOUT und schaltet diesen durch. Deshalb werden dessen Ausgang OUT und die gemeinsame Leitung L auf das niedrige Versorgungspotential VSS gezogen.

Entsprechendes gilt in einem vierten Fall (den der Fachmann anhand des vorstehend gesagten leicht selbst nachvollziehen kann), bei dem angenommen ist, daß bei der einen, betrachteteten Komparatoreinrichtung COMP am ersten Dateneingang IN1 und am weiteren zweiten Dateneingang $\overline{\text{IN2}}$ ein niedriges Potential anliegt und daß am weiteren ersten Dateneingang $\overline{\text{IN1}}$ und am zweiten Dateneingang IN2 ein hohes Potential anliegt: Auch in diesem Fall wird der Ausgangstransistor TOUT durchgeschaltet, so daß die gemeinsame Leitung L mit dem niedrigen Versorgungspotential VSS verbunden ist.

Zusammenfassend läßt sich also bezüglich der ersten Betriebsart, bei der alle Komparatoreinrichtungen COMP entlang einer gemeinsamen Leitung L mit Ausnahme einer einzigen Komparatoreinrichtung COMP inhibiert sind, folgendes sagen bezüglich der einen, nicht inhibierten Komparatoreinrichtung COMP: Liegen an den beiden Dateneingängen IN1, IN2 Daten D1, D2 an vom selben Wert (d. h. beide weisen entweder log. 0 oder log. 1 auf, also niedriges oder hohes Potential), so bleibt die gemeinsame Leitung L auf dem (vorgeladenen) hohen Potential, was z. B. einer log. 1 entspricht (positive Logik angenommen). Ansonsten weist die gemeinsame Leitung L ein niedriges Potential auf, d. h. log. 0. Die nicht-inhibierte Komparatoreinrichtung COMP wirkt also insgesamt als XNOR-Gatter, während der zweite Schaltungsknoten N2 das Verhalten des Ausgangs eines XOR-Gatters aufweist. Es ist jedoch auch möglich, die Komparatoreinrichtung COMP als XOR-Gatter auszulegen und zu betreiben: Dazu lädt man die gemeinsame Leitung L auf das niedrige Versorgungspotential VSS vor, verbindet den Disable-Transistor TDIS und den ggf. vorhandenen hochohmigen Widerstand R mit dem hohen Versorgungspotential VDD, verwendet als Disable-Transistor TDIS und als Ausgangstransistor TOUT Transistoren vom p-Kanal-Typ und verwendet als Disable-Signal DIS ein zum beschriebenen Disable-Signal DIS komplementäres Signal.

In einer zweiten Betriebsart wird nun angenommen, daß mehr als eine bis hin zu allen Komparatoreinrichtungen COMP entlang einer gemeinsamen Leitung L nicht inhibiert sind. Diese Betriebsart unterscheidet sich bezüglich jeder einzelnen Komparatoreinheit COMP nicht von der ersten Betriebsart. Es besteht aber ein Unterschied bezüglich der Gesamtheit der Komparator-Einrichtungen COMP: Die inhibierten Komparatoreinrichtungen COMP können zwar die gemeinsame Leitung L nicht beeinflussen (insoweit besteht Übereinstimmung mit der ersten Betriebsart), aber um die gemeinsame Leitung L von ihrem vorgeladenen Zustand (angenommenermaßen hohes Versorgungspotential VDD) auf den dazu komplementären Zustand (niedriges Versorgungspotential VSS) zu schalten, reicht es bereits aus, wenn bei einer einzigen der nicht-inhibierten Komparatoreinrichtungen COMP der Ausgang OUT auf das niedrige Versorgungspotential VSS geschaltet wird, d. h. wenn bei dieser wenigstens einen einzigen Komparatoreinrichtung COMP die zugehörigen Dateneingänge IN1, IN2 einander ungleiche Daten D1, D2 aufweisen.

Die Ausgänge OUT der nicht-inhibierten Komparatoreinrichtungen COMP wirken also bezüglich der gemeinsamen Leitung L wie Eingänge eines AND-Gatters: Sind sie alle in einem ersten (hochohmigen) Zustand, hat das dieselbe Wirkung, wie wenn sie ein hohes Potential lieferten, d. h. die gemeinsame Leitung L bleibt auf ihrem vorgeladenen, angenommenermaßen hohen Versorgungspotential VDD. Ist jedoch der Ausgangstransistor TOUT wenigstens einer der Komparatoreinrichtungen COMP durchgeschaltet, so wird die gemeinsame Leitung L über diesen Ausgangstransistor TOUT mit dem angenommenermaßen niedrigen Versorgungspotential VSS verbunden; die gemeinmsame Leitung L weist nun nicht mehr das vorgeladene hohe Versorgungspotential VDD auf, sondern das niedrige Versorgungspotential VSS.

Bei Vorladen der gemeinsamen Leitung L auf das niedrige Versorgungspotential VSS und Ausgestalten der Komparatoreinrichtungen COMP wie bezüglich der ersten Betriebsart hinsichtlich ihrer Auslegung als XOR-Gatter bereits beschrieben, wirkt die erfindungsgemäße Halbleiterspeicherschaltung entsprechend umgekehrt, nämlich als NAND-Gatter. Der Fachmann kann dies anhand des über die erste und die zweite Betriebsart bisher Gesagten leicht selbst nachvollziehen, so daß sich eine nähere Erläuterung erübrigt.

Bei Vorsehen von mehr als einer gemeinsamen Leitung L kann jede der gemeinsamen Leitungen L als Eingang für ein logisches Gatter LOG dienen, wie in FIG 2 gezeigt. Dabei ist jede Art von logischem Gatter möglich: AND, NAND, OR, NOR, XOR, XNOR.

Das Enable-Signal EN ermöglicht, diese zusätzlichen Vergleichsmöglichkeiten von Daten D1, $\overline{\text{D1}}$, D2, $\overline{\text{D2}}$, wie vorbeschrieben, auszunützen und die Vergleiche durchzuführen. Dies ist dann der Fall, wenn bei den Komparatoreinrichtungen COMP die Transistoren T3, T4 der zweiten Transistorpaare mittels des Enable-Signales EN leitend geschaltet sind. Sind sie mittels des Enable-Signales EN jedoch gesperrt, so ist die integrierte Halbleiterspeicherschaltung lediglich als üblicher integrierter Halbleiterspeicher betriebbar, d. h. ohne diese Vergleichsmöglichkeiten.

In einer dritten Betriebsart ist es bei jeder nicht-inhibierten Komparatoreinheit COMP möglich, die ersten Dateneingänge IN1; $\overline{IN1}$ als Datenausgänge zu benutzen und das am zweiten Dateneingang IN2 anliegende Datum D2 in eine, über eine Wortleitung WL adressierte, Speicherzelle MC einzuschreiben, die mit der einen Bitleitung BL verbunden ist bzw., falls die Wortleitung WL eine Speicherzelle MC adressiert, die mit der anderen Bitleitung $\overline{BL}$ verbunden ist, das am weiteren zweiten Dateneingang $\overline{IN2}$ anliegende Datum $\overline{D2}$ in die so adressierte Speicherzelle MC einzuschreiben, ohne beim Einschreiben, wie sonst üblich, die über die Bitleitungsdekoder BLDEC angesteuerten Auswahltransistoren TR zu verwenden. Dies funktioniert folgendermaßen:

Zunächst sei der Einfachheit halber angenommen, daß die über eine der Wortleitungen WL adressierte, zu beschreibende Speicherzelle MC mit der einen Bitleitung BL des ersten Bitleitungspaares BLP verbunden sei. An den zweiten Dateneingang IN2 wird das einzuschreibende Datum als zweites Datum D2 angelegt. Entsprechend wird an den weiteren zweiten Dateneingang $\overline{IN2}$ ein dazu komplementäres Datum als weiteres zweites Datum $\overline{D2}$ angelegt. Sowohl das Disable-Signal DIS wie auch das Enable-Signal EN sind aktiviert, so daß am ersten Schaltungsknoten N1 über das Mittel zum Inhibieren INH das Potential des zweiten Schaltungsknotens N2 anliegt. Dieses ist in der Ausführungsform nach FIG 10 wegen des durchgeschalteten Disable-Transistors TDIS gleich dem niedrigen Versorgungspotential VSS. Wenn nun das einzuschreibende zweite Datum D2 einen logischen Pegel mit hohem Potential (log. 1) aufweist, so ist der andere Transistor T2 des ersten Transistorpaares T1, T2 elektrisch leitend, während der eine Transistor T1 des ersten Transistorpaares T1, T2 gesperrt ist. An der anderen Bitleitung $\overline{BL}$ liegt somit das Potential des ersten Schaltungsknotens N1 an, d. h. das niedrige Versorgungspotential VSS. Nun wird der Leseverstärker SA, der bekanntlich ja auch als Schreibverstärker aktivierbar und betreibbar ist, aktiviert. Damit bleibt zwar die andere Bitleitung $\overline{BL}$ auf dem niedrigen Versorgungspotential VSS, die eine Bitleitung BL nimmt jedoch wegen der Funktion des Leseverstärkers SA (üblicherweise aus kreuzgekoppelten Transistoren aufgebaut) ein dazu komplementäres Potential, typischerweise das hohe Versorgungspotential VDD an (der Wert dieses hohen Potentials ist bekanntlich abhängig von den Versorgungspotentialen, mit denen der Leseverstärker SA betrieben wird; diese können unterschiedlich sein, insbesondere unterschiedlich zu dem hohen Versorgungspotential VDD der gesamten Halbleiterspeicherschaltung). Bei Adressieren der Speicherzelle MC über die zugehörige Wortleitung WL gelangt nun also das hohe Potential der einen Bitleitung BL in die Speicherzelle MC und wird dort eingeschrieben. Somit wird letztendlich der logische Wert des zweiten Datums D2 in die Speicherzelle MC eingeschrieben. Der große, überraschende Vorteil dieser dritten Betriebsart liegt darin, daß man Speicherzellen MC der Halbleiterspeicherschaltung beschreiben kann, ohne die Bitleitungspaare über die Bitleitungsdekoder BLDEC und die zugehörigen Auswahltransistoren TR adressieren zu müssen, d. h. unabhängig von diesbezüglichen Adreßdaten. Weiterhin ist es in dem Fall, in dem die ersten Dateneingänge IN1, $\overline{IN1}$ mit einem ersten Bitleitungspaar BLP verbunden sind und in dem die zweiten Dateneingänge IN2, $\overline{IN2}$ mit einem zweiten Bitleitungspaar BLP verbunden sind, möglich, mittels normaler Speicheradressierung das zweite Datum D2 aus einer Speicherzelle MC über das zugehörige zweite Bitleitungspaar BLP auszulesen, dieses an den zweiten Dateneingang IN2 sowie in komplementärer Form an den weiteren zweiten Dateneingang $\overline{IN2}$ anzulegen und anschließend, ohne Änderung der Adressierungsdaten, in diejenige Speicherzelle MC einzuschreiben, die einerseits mit derjenigen Wortleitung WL verbunden ist, mit der auch die soeben ausgelesene Speicherzelle MC verbunden ist, und die andererseits mit demjenigen ersten Bitleitungspaar BLP verbunden ist, welches wiederum mit den ersten Dateneingängen IN1, $\overline{IN1}$ der betrachteten Komparatoreinrichtung COMP verbunden ist. In einem Satz ausgedrückt: Die integrierte Halbleiterspeicherschaltung ermöglicht es in der dritten Betriebsart, in ersten Speicherzellen MC gespeicherte Daten in zweite Speicherzellen MC umzuschichten bzw. in diese hineinzukopieren.

Die erfindungsgemäße integrierte Halbleiterspeicherschaltung läßt sich aufgrund der möglichen, beschriebenen, vielseitigen Betriebsweisen insbesondere für Geräte der Unterhaltungselektronik einsetzen, wo eine Vielzahl von Speicherdaten zu verarbeiten ist, beispielsweise für Videotextbausteine. Aber auch für Speicher von Workstations von CAD-Systemen ist die Erfindung vorteilhaft anwendbar.

**Patentansprüche**

1. Integrierte Halbleiterspeicherschaltung
   - mit einer Vielzahl von Speicherzellen (MC) und Leseverstärkern (SA),

- mit Paaren (BLP) von Bitleitungen (BL, $\overline{BL}$), bei denen jedes Bitleitungspaar (BLP) mit einem der Leseverstärker (SA) verbunden ist und bei denen jede Bitleitung (BL, $\overline{BL}$) mit wenigstens einer der Speicherzellen (MC) verbunden ist,
- mit einer Vielzahl von Komparatoreinrichtungen (COMP), von denen jede einem Vergleich von wenigstens zwei Daten (D1, D2) dient, wobei das erste Datum (D1) über eine (BL; $\overline{BL}$) der Bitleitungen (BL, $\overline{BL}$) eines ersten der Bitleitungspaare (BLP) an einem ersten Dateneingang (IN1) der Komparatoreinrichtung (COMP) anliegt und wobei das zweite Datum (D2) an einem zweiten Dateneingang (IN2) der Komparatoreinrichtung (COMP) anliegt,
- die Komparatoreinrichtungen (COMP) sind ausgangsmäßig (OUT) mit einer gemeinsamen Leitung (L) verbunden,

gekennzeichnet durch folgende Merkmale:
jede Komparatoreinrichtung (COMP) weist ein Mittel zum Inhibieren (INH) ihres Ausganges (OUT) auf, wobei im Falle des Inhibierens der Ausgang (OUT) einen ersten elektrischen Zustand aufweist, der den elektrischen Zustand der gemeinsamen Leitung (L) unbeeinflußt läßt.

2. Integrierte Halbleiterspeicherschaltung nach Anspruch 1,
**dadurch gekennzeichnet**,
daß die Mittel zum Inhibieren (INH) der Ausgänge (OUT) der Komparatoreinrichtungen (COMP) einzeln aktivierbar sind.

3. Integrierte Halbleiterspeicherschaltung nach Anspruch 1,
**dadurch gekennzeichnet,**
daß die Mittel zum Inhibieren (INH) der Ausgänge (OUT) einer Gruppe von Komparatoreinrichtungen (COMP) gemeinsam aktivierbar sind.

4. Integrierte Halbleiterspeicherschaltung nach einem der vorhergehenden Ansprüche,
**dadurch gekennzeichnet,**
daß sie mehrere gemeinsame Leitungen (L) aufweist, wobei die Ausgänge (OUT) der Komparatoreinrichtungen (COMP) jeweils mit einer der mehreren gemeinsamen Leitungen (L) verbunden sind.

5. Integrierte Halbleiterspeicherschaltung nach einem der vorhergehenden Ansprüche,
**dadurch gekennzeichnet,**
daß der erste elektrische Zustand des Ausgangs (OUT) einer Komparatoreinrichtung (COMP) ein hochohmiger Zustand ist.

6. Integrierte Halbleiterspeicherschaltung nach einem der Ansprüche 1 bis 5,
**dadurch gekennzeichnet,**
daß das zweite Datum (D2) der zu vergleichenden Daten (D1, D2) in einem Register (REG) speicherbar ist.

7. Integrierte Halbleiterspeicherschaltung nach einem der Ansprüche 1 bis 5,
**dadurch gekennzeichnet,**
daß das zweite Datum (D2) der zu vergleichenden Daten (D1, D2) beim Vergleichsvorgang über eine Leitung (DI) zuführbar ist, die außerhalb des Vergleichsvorganges ein sonstiges Signal der Halbleiterspeicherschaltung führt.

8. Integrierte Halbleiterspeicherschaltung nach einem der Ansprüche 1 bis 5,
**dadurch gekennzeichnet,**
daß das zweite Datum (D2) der zu vergleichenden Daten (D1, D2) über eine (BL; $\overline{BL}$) der Bitleitungen (BL, $\overline{BL}$) eines zweiten der Bitleitungspaare (BLP) am zweiten Dateneingang (IN2) anliegt.

9. Integrierte Halbleiterspeicherschaltung nach einem der vorhergehenden Ansprüche,
**dadurch gekennzeichnet,**
daß das erste Datum (D1) in wahrer Form am ersten Dateneingang (IN1) anliegt und daß es in komplementärer Form ($\overline{D1}$) an einem weiteren ersten Dateneingang ($\overline{IN1}$) anliegt.

10. Integrierte Halbleiterspeicherschaltung nach einem der vorhergehenden Ansprüche,
**dadurch gekennzeichnet,**
daß das zweite Datum (D2) in wahrer Form am zweiten Dateneingang (IN2) anliegt und daß es in komplementärer Form ($\overline{D2}$) an einem weiteren zweiten Dateneingang ($\overline{IN2}$) anliegt.

11. Integrierte Halbleiterspeicherschaltung nach einem der vorhergehenden Ansprüche,
**dadurch gekennzeichnet,**
daß das Mittel zum Inhibieren (INH) über einen Steuereingang (CTRL) der Komparatoreinrichtung (COMP) mit einer der Bitleitungen (BL; $\overline{BL}$) eines weiteren, dritten Bitleitungspaares (BLP) verbunden ist.

12. Integrierte Halbleiterspeicherschaltung nach einem der Ansprüche 1 bis 11,
**dadurch gekennzeichnet,**
daß die gemeinsame Leitung (L) mit einem Anschlußpad (PD) eines die integrierte Halbleiterspeicherschaltung (MEM) enthaltenden Halbleiterchips (CH) verbunden ist.

**13.** Integrierte Halbleiterspeicherschaltung nach einem der Ansprüche 1 bis 11,
**dadurch gekennzeichnet,**
daß die integrierte Halbleiterspeicherschaltung (MEM) in einem Halbleiterchip (CH) enthalten ist, der darüber hinaus wenigstens ein elektronisches Schaltmittel (M) enthält und daß die gemeinsame Leitung (L) mit dem elektronischen Schaltmittel (M) verbunden ist.

**14.** Integrierte Halbleiterspeicherschaltung nach einem der Ansprüche 4 bis 11,
**dadurch gekennzeichnet,**
daß ein erster Teil der Gesamtzahl der gemeinsamen Leitungen (L) mit Anschlußpads (PD) eines die integrierte Halbleiterspeicherschaltung (MEM) enthaltenden Halbleiterchips (CH) verbunden ist und daß ein zweiter Teil der Gesamtzahl der gemeinsamen Leitungen (L) mit elektronischen Schaltmitteln (M) verbunden ist, die der Halbleiterchip (CH) zusätzlich zur integrierten Halbleiterspeicherschaltung (MEM) enthält.

**15.** Integrierte Halbleiterspeicherschaltung nach einem der vorhergehenden Ansprüche,
**dadurch gekennzeichnet,**
daß die Komparatoreinrichtungen (COMP) XOR-, XNOR-, OR-, NOR-, AND- oder NAND-Schaltungen enthalten.

**16.** Integrierte Halbleiterspeicherschaltung nach einem der vorhergehenden Ansprüche,
**dadurch gekennzeichnet,**
daß zwischen den Ausgängen (OUT) der Komparatoreinrichtungen (COMP) und der gemeinsamen Leitung (L) Transfertransistoren (TT) mit ihren Kanälen angeordnet sind.

**17.** Integrierte Halbleiterspeicherschaltung nach Anspruch 16,
**dadurch gekennzeichnet,**
daß die Gates der Transfertransistoren (TT) gemeinsam mit einem Steuersignal ($\phi$TT) beaufschlagt sind.

**18.** Integrierte Halbleiterspeicherschaltung nach einem der Ansprüche 10 bis 17,
**dadurch gekennzeichnet,**
daß eine Komparatoreinrichtung (COMP) folgende Merkmale aufweist:
- zwischen dem ersten Dateneingang (IN1) und einem ersten Schaltungsknoten (N1) der Komparatoreinrichtung (COMP) sowie zwischen dem weiteren ersten Dateneingang ($\overline{IN1}$) und dem ersten Schaltungsknoten (N1) sind jeweils ein Transistor (T1; T2) eines ersten Transistorpaares (T1, T2) und ein Transistor (T3; T4) eines zweiten Transistorpaares (T3, T4) mit ihren stromführenden Pfaden in Serie zueinander geschaltet,
- das Gate des einen Transistors (T1) des ersten Transistorpaares (T1, T2) ist mit dem weiteren zweiten Dateneingang ($\overline{IN2}$) verbunden,
- das Gate des anderen Transistors (T2) des ersten Transistorpaares (T1, T2) ist mit dem zweiten Dateneingang (IN2) verbunden,
- die Gates des zweiten Transistorpaares (T3, T4) sind mit einem Enable-Signal (EN) beaufschlagbar,
- zwischen dem ersten (N1) und einem zweiten Schaltungsknoten (N2) ist das Mittel zum Inhibieren (INH) des Ausgangs (OUT) der Komparatoreinrichtung (COMP) angeordnet,
- zwischen dem zweiten Schaltungsknoten (N2) und einem der Versorgungspotentiale (VSS; VDD) der integrierten Halbleiterspeicherschaltung ist ein Disable-Transistor (TDIS) mit seinem stromführenden Pfad angeordnet, dessen Gate mit einem Disable-Signal (DIS) beaufschlagbar ist,
- der zweite Schaltungsknoten (N2) ist weiterhin mit dem Gate eines Ausgangstransistors (TOUT) verbunden, dessen stromführender Pfad zwischen einem (VSS; VDD) der Versorgungspotentiale (VSS, VDD) der integrierten Halbleiterspeicherschaltung und deren Ausgang (OUT) liegt.

**19.** Integrierte Halbleiterspeicherschaltung nach Anspruch 18,
**dadurch gekennzeichnet,**
daß das Disable-Signal (DIS) komplementär ist zum Enable-Signal (EN).

**20.** Integrierte Halbleiterspeicherschaltung nach Anspruch 18,
**dadurch gekennzeichnet,**
daß das Disable-Signal (DIS) wenigstens zeitweise gleich ist dem Enable-Signal (EN).

# FIG 1

## FIG 2

## FIG 3

## FIG 4

# FIG 5

EP 0 533 996 A1

# FIG 6

14

# FIG 7

**FIG 8**

**FIG 9**

**FIG 10**

16

Europäisches Patentamt

EUROPÄISCHER RECHERCHENBERICHT

Nummer der Anmeldung

EP    91 11 6606

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.5) |
|---|---|---|---|
| A | EP-A-0 354 265 (SIEMENS)<br><br>* das ganze Dokument *<br>--- | 1,2,7-9,<br>12,15-17 | G11C7/00<br>G06F7/02 |
| A | RESEARCH DISCLOSURE<br>Nr. 311, März 1990, NEW YORK; USA<br>Seite 194;<br>ANONYMOUSLY: 'ARRAY COMPARE'<br>* das ganze Dokument *<br>--- | 1,9 | |
| A | FR-A-2 444 296 (HONEYWELL INFORMATION SYSTEMS)<br>* Seite 6, Zeile 19 - Seite 6, Zeile 39;<br>Abbildungen 5,6 *<br>--- | 1,4 | |
| A | FR-A-1 359 440 (NIPPON ELECTRIC COMPANY)<br>* das ganze Dokument *<br><br>----- | 1,7 | |
| | | | RECHERCHIERTE SACHGEBIETE (Int. Cl.5)<br><br>G11C<br>G06F |

Der vorliegende Recherchenbericht wurde für alle Patentansprüche erstellt

| Recherchenort | Abschlußdatum der Recherche | Prüfer |
|---|---|---|
| DEN HAAG | 15 JUNI 1992 | DEGRAEVE L.W.G. |